# EUROPÄISCHE PATENTSCHRIFT

(11) **EP 2 513 845 B1**
(45) Veröffentlichungstag und Bekanntmachung des Hinweises auf die Patenterteilung: **06.11.2013**
(21) Anmeldenummer: 10795944.7
(22) Anmeldetag: 13.12.2010
(51) Int. Cl.: G06K 19/077

(54) **BEFESTIGEN UND ELEKTRISCH LEITENDES VERBINDEN EINES CHIPMODULS MIT EINER CHIPKARTE**
FIXING AND CONNECTING A CHIP MODULE TO A CHIP CARD IN AN ELECTRICALLY CONDUCTIVE MANNER
FIXATION ET RACCORDEMENT ÉLECTROCONDUCTEUR D'UN MODULE DE PUCE À UNE CARTE À PUCE

(30) Priorität: 16.12.2009 DE 102009058435
(43) Veröffentlichungstag der Anmeldung: 24.10.2012
(73) Patentinhaber: Giesecke & Devrient GmbH, 81677 München (DE)
(72) Erfinder: BADER, Johannes, 82496 Oberau (DE)
(74) Vertreter: Niedermeier, Peter
(86) Internationale Anmeldenummer: PCT/EP2010/007580
(87) Internationale Veröffentlichungsnummer: WO 2011/082765

(56) Entgegenhaltungen:
- DE-A1- 19 703 990
- US-A1- 2003 132 302

## Beschreibung

Die vorliegende Erfindung betrifft ein Verfahren zum Herstellen einer Chipkarte durch elektrisch leitendes Verbinden eines Chipmoduls mit einem Chipkartenkörper sowie eine derartige Chipkarte.

Es ist bekannt, Chipmodule von Chipkarten mittels elektrisch leitfähigem Silikon mit Kontaktflächen eines Chipkartenkörpers elektrisch leitend zu verbinden. Das Silikon wird hierzu haftend auf etwaige Kontaktflächen des Chipkartenkörpers aufgebracht und erstarrt, wodurch eine als Flex Bump bezeichnete Silikonerhebung erzeugt wird, auf die das Chipmodul anschließend derart aufgesetzt wird, dass eine elektrisch leitende Verbindung zu dem Chipmodul entsteht, welche Biegungen und Verwindungen der fertigen Chipkarte flexibel kompensieren kann.

Diese Flexibilität verliert das Silikon jedoch mit der Zeit, wodurch auch die elektrische Verbindung verloren gehen kann. Dies ist insbesondere bei langlebigen hochwertigen Chipkarten problematisch.

Ein weiterer Nachteil derartiger Verbindungen zwischen Chipmodul und Chipkartenkörper ist das relativ schnelle Erstarren des Silikons, wodurch dessen Hafteigenschaften unwiderruflich verloren gehen, so dass das Chipmodul auf den Kartenkörper nur berührend aufgesetzt und nicht haftend aufgebracht werden kann. Ein gleichzeitiges Aufbringen des Silikons auf den Chipkartenkörper und des Chipmoduls auf das noch nicht erstarrte Silikon ist demgegenüber verfahrensbedingt nicht möglich.

DE 19703990 offenbart ein Verfahren zum Herstellen einer Chipkarte durch elektrisch leitendes Verbinden eines Chipmoduls mit einem Chipkartenkörper.

Aufgabe der vorliegenden Erfindung ist es daher, eine dauerhaft robuste, elektrisch leitende Verbindung zwischen Chipmodul und Chipkartenkörper herzustellen.

Diese Aufgabe wird durch ein Verfahren sowie durch eine Chipkarte mit den Merkmalen der unabhängigen Ansprüche 1 und 12 gelöst. In davon abhängigen Ansprüchen sind vorteilhafte Ausgestaltungen und Weiterbildungen der Erfindung angegeben.

Eine Chipkarte wird durch Einbringen eines Chipmoduls in einen Chipkartenkörper hergestellt. Bei Chipkarten, die eine elektrisch leitende Verbindung zwischen Kontaktflächen des Chipkartenkörpers und dem Chipmodul erfordern, z.B. zum Anschließen einer in die Chipkarte integrierten Antenne, wird ein Chipmodul elektrisch leitend mit einem Chipkartenkörper verbunden. Hierzu wird das Chipmodul erfindungsgemäß mittels eines thermoplastischen, elektrisch leitfähigen Elastomermaterials haftend mit dem Chipkartenkörper derart verbunden, dass das Chipmodul zugleich mit der zumindest einen elektrischen Kontaktfläche des Chipkartenkörpers elektrisch leitend verbunden wird.

Hierdurch können für jede zu kontaktierende Kontaktstelle jeweils zwei haftende Verbindungen erzeugt werden, nämlich diejenige zwischen dem Elastomermaterial und der Kontaktfläche und diejenige zwischen Elastomermaterial und dem Chipmodul. Diese haftenden Verbindungen sowie das Elastomermaterial sind zugleich elektrisch leitend. Bei derartig hergestellten Chipkarten ist das Chipmodul mittels des Elastomermaterials haftend mit dem Chipkartenkörper derart verbunden, dass das Chipmodul mit zumindest einer elektrischen Kontaktfläche elektrisch leitend verbunden ist.

Da das Elastomermaterial sowohl mit dem Chipmodul als auch mit dem Chipkartenkörper bzw. mit seinen Kontaktflächen haftend verbunden ist, reicht ein weniger flexibles Elastomermaterial zur Sicherstellung einer stabilen elektrisch leitenden Verbindung zwischen Chipmodul und Kontaktfläche aus. Wesentliches Kriterium für die Beständigkeit der elektrisch leitenden Verbindung ist die Stärke der haftenden Verbindung. Aus diesem Grund kann bei einer beidseitig haftenden Verbindung ein Silikon, insbesondere ein thermoplastisches Silikon, von mittlerer oder geringer Flexibilität verwendet werden, um mechanische Belastungen, wie z.B. Biegungen und Verwindungen, flexibel zu kompensieren.

Dazu kommt, dass bestimmte thermoplastische Elastomere eine sehr hohe Flexibilität über einen weiten Temperaturbereich und über einen langen Zeitraum gewährleisten, so dass mit thermoplastischen, elektrisch leitfähigen Elastomeren eine sehr robuste elektrisch leitende Verbindung zwischen dem Chipmodul und dem Chipkartenkörper hergestellt werden kann.

Bevorzugt handelt es sich bei der Chipkarte um eine Kontaktlos-Chipkarte, d.h. eine Chipkarte mit einer kontaktlosen Datenübertragungsschnittstelle, oder eine Dual-Interface-Chipkarte, d.h. eine Chipkarte mit kontaktbehafteter und kontaktloser Datenübertragungsschnittstelle, z.B. mit einer in den Chipkartenkörper eingelassenen Antenne. Die Antenne ist dann über das elektrisch leitende, beidseitig haftende Elastomermaterial mit dem Chipmodul verbunden.

Zum haftenden Verbinden des Chipmoduls mit dem Chipkartenkörper kann zunächst erwärmtes und aufgeschmolzenes Elastomermaterial zumindest auf eine Kontaktfläche des Chipkartenkörpers haftend aufgebracht werden und zumindest teilweise erstarren. Zu einem beliebigen späteren Zeitpunkt kann das bereits erstarrte Elastomer zumindest teilweise wieder erwärmt und aufgeschmolzen und damit haftend gemacht werden und das Chipmodul kann haftend auf das Elastomermaterial aufgebracht werden.

Gemäß der Erfindung wird ein Chipkartenkörper zur Verfügung gestellt, in welchem sich eine Vertiefung befindet, in die ein Chipmodul eingesetzt wird. In der Vertiefung befindet sich mindestens eine Kontaktfläche um eine elektrisch leitende Verbindung mit einer entsprechenden Kontaktfläche des Chipmoduls herzustellen, wobei das Chipmodul mindestens eine Kontaktfläche hat. Dazu wird das Elastomermaterial zunächst auf eine Temperatur erwärmt und aufgeschmolzen, bei der es mit den Kontaktflächen des Chipkartenkörpers eine haftende Verbindung eingehen kann und wird dann auf die betreffenden Kontaktflächen aufgebracht. Das Elastomermaterial kühlt dann rasch ab und erstarrt dadurch zumindest teilweise. Anschließend wird das Chipmodul so eingesetzt, daß das Elastomermaterial Kontaktflächen des Chipmoduls berührt. Um mit den Kontaktflächen des Chipmoduls eine weitere haftende Verbindung eingehen zu können, wird das Elastomermaterial zumindest an solchen Stellen der Oberfläche, an denen eine haftende Verbindung mit den Kontaktflächen des Chipmoduls eingerichtet werden soll, bis auf eine geeignete Temperatur durch den Chipkartenkörper und/oder das Chipmodul hindurch erneut erwärmt und aufgeschmolzen, so daß eine weitere haftende Verbindung zwischen dem Elastomermaterial und den Kontaktflächen des Chipmoduls gebildet wird. Somit wird eine elektrisch leitende Verbindung zwischen den Kontaktflächen des Chipmoduls und den Kontaktflächen des Chipkartenkörpers hergestellt.

In einem modifizierten Verfahren wird das erwärmte und aufgeschmolzene Elastomermaterial zunächst auf das Chipmodul aufgebracht und erstarrt dort zumindest teilweise. Nachdem das Chipmodul in den Chipkartenkörper eingesetzt wurde, wird das Elastomer durch das Chipmodul und/oder den Chipkartenkörper hindurch teilweise erneut erwärmt und aufgeschmolzen um mit den Kontaktflächen des Chipkartenkörpers eine weitere haftende Verbindung herzustellen.

Das Elastomermaterial wird also zunächst auf eine Temperatur erwärmt und aufgeschmolzen, bei der es mit dem Chipmodul eine haftende Verbindung eingehen kann und dann auf das Chipmodul aufgebracht, wo es rasch abkühlt und erstarrt. Nachdem das Chipmodul in den Chipkartenkörper eingesetzt wurde, wird uu einem nahezu beliebigen späteren Zeitpunkt das Elastomermaterial zumindest an solchen Stellen der Oberfläche, an denen es mit dem Chipkartenkörper eine haftende Verbindung eingehen soll, durch das Chipmodul und/oder den Chipkartenkörper hindurch auf eine geeignete Temperatur erneut erwärmt und aufgeschmolzen um eine weitere haftende Verbindung mit den Kontaktflächen des Chipkartenkörpers herzustellen. Hierdurch entsteht eine elektrisch leitende Verbindung zuwischen dem Chipmodul und der Kontaktfläche des Chipkartenkörpers über das elektrisch leitende Elastomermaterial.

Das Elastomermaterial wird bevorzugt mit einer herkömmlichen Dosiereinheit für Heißklebestoffe ("Hotmelts") oder einer Spritzgussmaschine haftend aufgebracht.

Alternativ kann das Elastomermaterial auch in Form einer Folie bereitgestellt werden. Diese wird bevorzugt auf eine Temperatur erwärmt und aufgeschmolzen, die zum Ausbilden einer entsprechenden haftenden Verbindung geeignet ist, und dann zuerst auf die Kontaktflächen des Chipkartenkörpers oder auf die Kontaktflächen des Chipmoduls haftend aufgebracht. Nach dem Erstarren des Elastomermaterials wird dann das Chipmodul in den Chipkartenkörper eingesetzt und durch wiederholtes Erwärmen und Aufschmelzen des Elastomermaterials durch den Chipkartenkörper und/oder das Chipmodul hindurch eine weitere haftende Verbindung mit den Kontakten des Chipmoduls oder des Chipkartenkörpers hergestellt.

Als thermoplastisches, elektrisch leitfähiges Elastomermaterial kommt insbesondere ein Elastomermaterial mit elektrisch leitendem Füllstoff in Frage. Besonders bevorzugt wird ein thermoplastisches Silikon verwendet, insbesondere ein Silikon vom Typ GENIOMER^{©} der Wacker Chemie AG, dem bevorzugt ein elektrisch leitfähiger Füllstoff beigefügt ist.

Das Elastomermaterial stellt die notwendige Haftung bereit, ist ausreichend stabil und langlebig und besitzt eine relativ gleichmäßige Elastizität über einen weiten Temperaturbereich und eine lange Lebensdauer. Im Gegensatz zu einigen klassischen thermoplastischen Elastomeren auf Styrol- oder Polyolefinbasis, die über einen breiten Temperaturbereich eine eingeschränkte Elastizität aufweisen oder bei zu niedrigen Temperaturen erstarren, besitzt ein Elastomermaterial vom Typ GENIOMER^{©} einen breiten Temperaturbereich und insbesondere auch bei niedrigen Temperaturen eine sehr gute Elastizität.

Besonders bevorzugt wird ein Elastomermaterial verwendet, das beim haftenden Verbinden des Chipmoduls an dem Chipkartenkörper bei Temperaturen eine Haftverbindung mit dem Chipmodul und/oder dem Chipkartenkörper eingehen kann, die unterhalb einer maximalen Temperaturbelastung des Chipmoduls und/oder des Chipkartenkörpers liegen. Hierdurch wird vermieden, dass das Chipmodul oder der Chipkartenkörper durch das erneute Erhitzen und haftende Aufbringen des erwärmten und aufgeschmolzenen Elastomermaterials beschädigt werden.

Ebenso bevorzugt wird ein Elastomermaterial verwendet, bei dem die mechanische Belastbarkeit der haftenden Verbindung zwischen dem Chipmodul und dem Chipkartenkörper optimiert ist. Insbesondere kann ein Elastomermaterial verwendet werden, dem ein oder mehrere geeignete Additive beigemischt sind.

Zur Verbesserung der Haftung kann ein Haftvermittler, sogenannter Primer, auf der Oberfläche der Kontakte von Chipmodul und/oder Chipkartenkörper aufgebracht werden.

Weitere Merkmale und Vorteile der Erfindung ergeben sich aus der folgenden Beschreibung der erfindungsgemäßen Ausführungsbeispiele sowie weiteren Ausführungsalternativen im Zusammenhang mit den Zeichnungen, die zeigen:
- Fig. 1: eine erfindungsgemäße Chipkarte;
- Fig. 2: Schritte eines Verfahrensablaufs zur Herstellung der Chipkarte nach Fig. 1; und
- Fig. 3: Schritte eines alternativen Verfahrensablaufs zur Herstellung der Chipkarte nach Fig. 1.

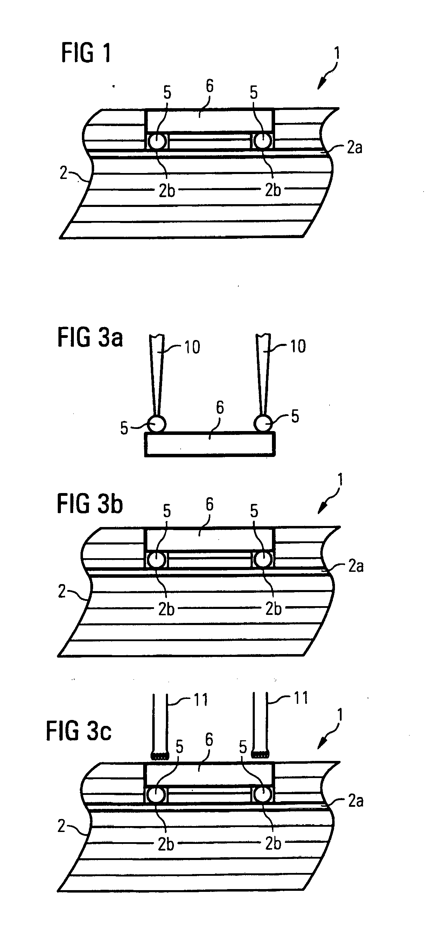

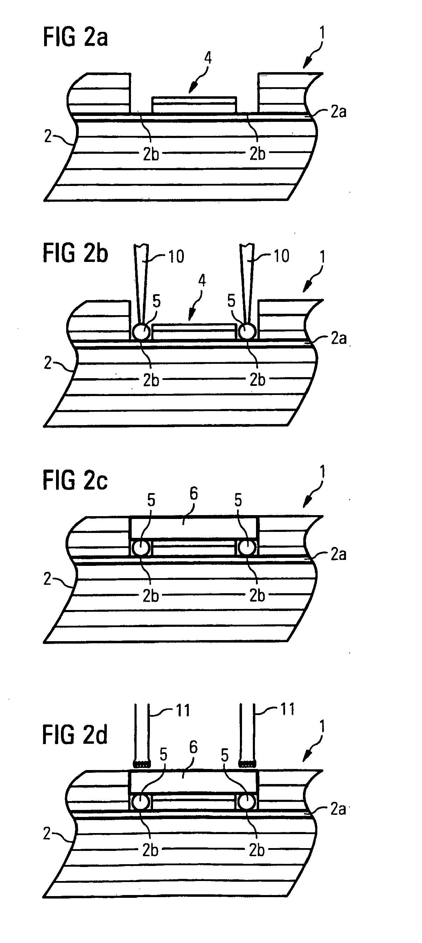

Während die Figuren 2 und 3 zwei alternative Verfahren zum Herstellen einer Chipkarte 1 illustrieren, zeigt Fig. 1 in schematischer Weise eine derartige Chipkarte 1 mit einem Chipmodul 6, welches mittels eines thermoplastischen, elektrisch leitfähigen Elastomermaterials 5 haftend mit dem Chipkartenkörper 2 verbunden ist, wobei das Chipmodul 6 durch das Elastomermaterial 5 zugleich mit den elektrischen Kontaktflächen 2b des Chipkartenkörpers 2 leitend verbunden ist.

Der Chipkartenkörper 2 der Chipkarte 1 ist gemäß Fig. 1 aus verschiedenen, durch parallele Linien angedeutete Schichten aufgebaut. In dem Chipkartenkörper 2 ist eine Antennenschicht 2a eingearbeitet, die z.B. als aufgedruckte Spule, d.h. als ein elektrisch leitfähiger Aufdruck in Form einer als Antenne dienenden Spule, oder dergleichen realisiert sein kann. Des Weiteren besitzt der Chipkartenkörper 2 eine Aussparung 4 (vgl. Fig. 2a bis 2c), in die das Chipmodul 6 eingesetzt ist. Unterhalb des Chipmoduls 6 befinden sich innerhalb der Aussparung 4 zwei Flex-Bump-Strukturen 5 aus einem thermoplastischen, elektrisch leitfähigen Silikon. Die Flex Bumps 5 sind haftend und gleichzeitig elektrisch leitend mit Kontaktflächen 2b der Spulenschicht 2a des Chipkartenkörpers 2 und dem Chipmodul 6 verbunden, und sorgen dadurch gleichzeitig für eine haftende und eine elektrisch leitende Verbindung zwischen diesen beiden Komponenten 2b, 6.

Im Ausführungsbeispiel der Fig. 1 repräsentieren die Kontaktflächen 2b der Spulenschicht 2a die zugänglichen Stellen der Spulenschicht 2a, die durch punktuelle tiefere Aussparungen in dem Chipkartenkörper 2 gebildet werden. Alternativ können die Kontaktflächen 2b auch besonders ausgestaltet sein, z.B. mit einer besonders gut elektrisch leitenden Beschichtung versehen sein oder dergleichen. Generell müssen die Kontaktflächen 2b als Kontaktflächen des Chipkartenkörpers 2 nicht mit einer Spulenschicht 2a elektrisch leitend verbunden sein, sondern können mit beliebigen elektrischen Komponenten des Chipkartenkörpers 2 elektrisch leitend verbunden sein, z.B. mit einer Stromquelle. Zudem können die Flex Bumps 5 neben den Kontaktflächen 2b auch mit weiteren Stellen des Chipkartenkörpers 2 haftend verbunden sein, um eine besonders robuste Haftverbindung zu erzeugen. In diesem Fall bildet die Kontaktfläche 2b nur einen Teil der Fläche, mit der der Flex Bump 5 mit dem Chipkartenkörper 2 haftend verbunden ist.

Um die Spulenschicht 2a bzw. im allgemeinen Fall die entsprechende elektrische Komponente des Chipkartenkörpers 2 anzusteuern, besitzt das Chipmodul 6 ebenfalls Kontaktflächen (nicht dargestellt), die durch die Flex Bumps 5 geeignet mit der Spulenschicht 2a bzw. im allgemeinen Fall mit der entsprechenden elektrischen Komponente des Chipkartenkörpers 2 verbunden sind.

Der Chipkartenkörper 2 der Chipkarte 1 ist besonders bevorzugt in einem Format gemäß ISO 7816 ausgestaltet. Besonders bevorzugt handelt es sich bei der Chipkarte 1 um eine Chipkarte 1 mit Kontaktlosschnittstelle, z.B. um eine Dual-Interface-Chipkarte mit kontaktloser und kontaktbehafteter Schnittstelle zur Datenübertragung.

Fig. 2 illustriert einen bevorzugten Verfahrensablauf zur Herstellung der Chipkarte 1 der Fig. 1. Hierbei wird zunächst in Fig. 2a ein geeigneter Chipkartenkörper 2 zur Verfügung gestellt, der mehrschichtig aufgebaut ist und eine Antennenschicht 2a umfasst. In dem Chipkartenkörper 2 ist eine Aussparung 4 zum Einsetzen eines Chipmoduls 6 vorgesehen, wobei über die Aussparung 4 die Kontaktflächen 2b der Antennenschicht 2a durch punktuelle tiefere Aussparungen zugänglich sind.

Fig. 2b zeigt, wie das erwärmte und aufgeschmolzene Elastomermaterial 5 mittels des Aufbringwerkzeugs 10 auf die Kontaktfläche 2b aufgebracht wird, nachdem es zuvor auf eine Temperatur erwärmt und aufgeschmolzen wurde, bei der es mit den Kontaktflächen 2b eine leitende Verbindung eingehen kann. Hierbei wird das Elastomermaterial 5 geeignet dosiert und in einer hinreichend genau definierten Form aufgebracht, um z.B. Kurzschlüsse zu vermeiden. Generell kann zum Aufbringen des Elastomermaterials 5 unter anderem eine herkömmliche Dosiereinheit für Heißklebestoffe oder eine Spritzgussmaschine verwendet werden. Alternativ kann das Elastomermaterial 5 auch in Form einer Folie bereitgestellt, erwärmt und aufgeschmolzen und dann aufgebracht werden. Durch das Aufbringen des erwärmten und aufgeschmolzenen Elastomermaterials 5 entsteht eine haftende Verbindung des Elastomermaterials 5 mit der Kontaktfläche 2b.

Anschließend kühlt das aufgebrachte Elastomermaterial 5 ab und erstarrt zumindest teilweise, so dass es keine weitere haftende Verbindung mehr eingehen kann. Anschließend wird das Chipmodul 6 in die Aussparung 4 derart eingebracht, so dass das elektrisch leitfähige Elastomermaterial 5 in Form von Flex Bumps gegenüber dem Chipmodul 6 liegt, siehe Figur 2c. Um eine weitere haftende Verbindung mit dem Chipmodul 6 herzustellen wird in Fig. 2d das aufgebrachte Elastomermaterial 5 zu einem nahezu beliebigen späteren Zeitpunkt mit einem Erhitzwerkzeug 11 durch das Chipmodul 6 hindurch erneut erwärmt und aufgeschmolzen. Alternativ kann das Elastomermaterial auch durch den Chipkartenkörper 2 hindurch erwärmt und aufgeschmolzen werden. Dabei wird es auf eine Temperatur erwärmt und aufgeschmolzen, bei der es einerseits mit dem Chipmodul 6 eine weitere haftende Verbindung eingehen kann und andererseits den Chipkartenkartenkörper 2 und das Chipmodul 6 nicht schädigt. Dabei genügt es, wenn das Elastomermaterial 5 an der Oberfläche, welche eine weitere haftende Verbindung mit dem Chipmodul 6 eingehen soll, auf diese Temperatur erwärmt und aufgeschmolzen wird. Gleichzeitig zur Herstellung einer haftenden Verbindung wird eine elektrisch leitende Verbindung zwischen dem Chipmodul 6 und den Kontaktflächen 2b hergestellt. Die fertige Chipkarte 1 mit eingesetztem sowie haftend und leitend verbundenem Chipmodul 6 ist in Fig. 2d gezeigt und entspricht der in Fig. 1 dargestellten Chipkarte 1.

Fig. 3 zeigt ein alternatives Verfahren zur Herstellung der in Fig. 1 dargestellten Chipkarte 1. Dieses Verfahren unterscheidet sich von dem in Fig. 2 dargestellten Verfahren dadurch, dass das erwärmte und aufgeschmolzene Elastomermaterial 5 mit dem Aufbringwerkzeug 10 nicht wie in Fig. 2b auf die Kontaktflächen 2b des Chipkartenkörpers 2 aufgebracht wird, sondern wie in Fig. 3a dargestellt auf das Chipmodul 6. Die Dosierung und Formgebung des Elastomermaterials kann wie im Zusammenhang mit Fig. 2b beschrieben erfolgen. Auch kann in Analogie zu dem in Fig. 2b beschriebenen Verfahrensschritt das Elastomermaterial alternativ in Form einer Folie bereitgestellt, erwärmt und aufgeschmolzen und dann aufgebracht werden. Die Temperatur des erwärmten und aufgeschmolzenen Elastomermaterials 5 wird derart gewählt, dass dieses mit dem Chipmodul 6 eine haftende Verbindung eingeht und das Chipmodul 6 nicht beschädigt.

Anschließend wird in Figur 3b das Chipmodul 6 mit dem Elastomermaterial 5 in Form von Flex Bumps in den Chipkartenkörper 2 eingesetzt, so dass sich die Flex Bumps 5 und die Kontaktflächen 2b der Spulenschicht 2a gegenüber liegen. Das abgekühlte und zumindest teilweise erstarrte Elastomermaterial wird in Analogie zu dem in Fig. 2c dargestellten Verfahrensschritt erneut in Figur 3c durch das Chipmodul 6 hindurch auf eine geeignete Temperatur erwärmt und aufgeschmolzen, damit dieses eine haftende Verbindung mit den Kontaktflächen 2b des Chipkartenkörpers 2 eingehen kann. Alternativ kann das Elastomermaterial auch durch den Chipkartenkörper 2 hindurch erwärmt und aufgeschmolzen werden. Hierdurch wird in Analogie zu dem in Fig. 2 dargestellten Verfahren zugleich eine elektrisch leitende Verbindung zwischen dem Chipmodul 6 und den Kontaktflächen 2b hergestellt. Die mit diesem alternativen Verfahren erzeugte Chipkarte 1 ist in Fig. 3c dargestellt und entspricht der in Fig. 2d und Fig. 1 dargestellten Chipkarte 1.

Bei beiden Verfahren wird ein Elastomermaterial 5 verwendet, das bei Temperaturen eine Haftverbindung mit dem Chipmodul 6 und/oder dem Chipkartenkörper 2 eingehen kann, die unterhalb einer maximalen Temperaturbelastung des Chipmoduls 6 und/oder des Chipkartenkörpers 2 liegen. Da die maximale Temperaturbelastung in der Regel nicht für das gesamte Chipmodul 6 oder den gesamten Chipkartenkörper 2 gleich ist, muss nicht das gesamte Chipmodul 6 bzw. der gesamten Chipkartenkörper 2 der Temperatur des erwärmten und aufgeschmolzenen Elastomermaterials 5 standhalten können, sondern vorzugsweise nur diejenigen Teile, die mit dem erhitzen Elastomermaterial 5 in Berührung kommen bzw. die in dessen Nähe liegen. Ein durch das Gehäuse des Chipmoduls 6 geschützter Chip muss beispielsweise nur einer entsprechend niedrigeren Temperaturbelastung standhalten, welche von verschiedenen Parametern abhängt, wie z.B. der Menge an aufgebrachtem erwärmten und aufgeschmolzenen Elastomermaterial 5. Um sicherzustellen, dass das Elastomermaterial 5 bei Temperaturen eine Haftverbindung mit dem Chipmodul 6 und/oder dem Chipkartenkörper 2 eingehen kann, welche unterhalb einer maximalen Temperaturbelastung des Chipmoduls 6 und/oder des Chipkartenkörpers 2 liegen, können das Elastomermaterial 5 in seiner Zusammensetzung sowie die Komponenten und der Aufbau des Chipmoduls 6 und/oder des Chipkartenkörpers 2 sowie weitere Parameter optimiert werden, wie z.B. durch geeignete Additive oder dergleichen.

Als Aufbringwerkzeug 10 kann für beide Verfahren eine herkömmliche Dosiereinheit für Heißklebestoffe ("Hotmelts") oder eine Spritzgussmaschine eingesetzt werden. Falls eine solche Dosiereinheit für Heißklebestoffe verwendet wird, ist darauf zu achten, dass das aufzubringende erwärmte und aufgeschmolzene Elastomermaterial 5 eine ausreichende Homogenität aufweist, damit es sich fehlerfrei verarbeiten lässt. Als Spritzgussmaschine wird bevorzugt eine Maschine verwendet, die in vertikaler Richtung arbeitet, d.h., die das Elastomermaterial 5 in vertikaler Richtung (insbesondere von oben) aufbringt.

Als thermoplastisches, elektrisch leitfähiges Elastomermaterial 5 kommt bei beiden Verfahren insbesondere ein Elastomermaterial 5 mit elektrisch leitendem Füllstoff in Frage. Besonders bevorzugt wird ein thermoplastisches Silikon verwendet, insbesondere ein Silikon vom Typ GENIOMER^{©} der Wacker Chemie AG, dem bevorzugt ein elektrisch leitfähiger Füllstoff beigefügt wird.

Die Stärke der haftenden Verbindung des Elastomermaterials 5 mit dem Chipmodul 6 und dem Chipkartenkörper 2 kann bei beiden Verfahren optimiert werden, insbesondere durch Optimierung des Elastomermaterials 5. Insbesondere kann ein Elastomermaterial 5 verwendet werden, dem ein oder mehrere geeignete Additive beigemischt sind und/oder auf dessen Oberfläche ein Haftvermittler aufgebracht ist. Ebenso kann die Beschaffenheit der entsprechenden Oberflächen des Chipmoduls 6 und des Chipkartenkörpers 2 (insbesondere der Kontaktflächen 2b des Chipkartenkörpers 2) optimiert werden, beispielsweise wiederum durch ein entsprechendes Additiv und/oder durch Aufbringen eines Haftvermittlers.

Bei beiden Verfahren werden die Chipkartenkörper 2 bevorzugt automatisch mit dem Aufbringwerkzeug 10 und/oder dem Erhitzwerkzeug 11 und/oder weiteren Werkzeugen bzw. Maschinen zugeführt und diesen entnommen, entweder in Linie, d.h. z.B. per Fließband, oder auch einzeln, d.h. z.B. mittels eines Roboters.

## Patentansprüche

1. Verfahren zum Herstellen einer Chipkarte (1) durch elektrisch leitendes Verbinden eines Chipmoduls (6) mit einem Chipkartenkörper (2),
**dadurch gekennzeichnet, dass** das Chipmodul (6) mittels eines thermoplastischen, elektrisch leitfähigen Elastomermaterials (5) mit dem Chipkartenkörper (2) haftend verbunden wird, so dass das Chipmodul (6) mit zumindest einer elektrischen Kontaktfläche (2b) des Chipkartenkörpers (2) elektrisch leitend verbunden wird.

2. Verfahren nach Anspruch 1, **dadurch gekennzeichnet, dass** das Chipmodul (6) elektrisch leitend mit zumindest einer elektrischen Kontaktfläche (2b) einer Antenne (2a) in dem Chipkartenkörper (2) verbunden wird.

3. Verfahren nach Anspruch 1 oder 2, **dadurch gekennzeichnet, dass** das haftende Verbinden des Chipmoduls (6) mit dem Chipkartenkörper (2) die folgenden Schritte umfasst:
- haftendes Aufbringen des erwärmten und aufgeschmolzenen Elastomermaterials (5) zumindest auf die zumindest eine Kontaktfläche (2b) des Chipkartenkörpers (2) und zumindest teilweises Erstarren des Elastomermaterials (5),
- Aufbringen des Chipmoduls (6) auf das zumindest teilweise erstarrte Elastomermaterial (5) des Chipkartenkörpers (2),
- erneutes Erwärmen und Aufschmelzen des Elastomermaterials (5) durch den Chipkartenkörper (2) und/oder das Chipmodul (6) hindurch, so daß eine weitere haftende Verbindung zwischen dem Elastomermaterial (5) und den Kontaktflächen des Chipmoduls (6) gebildet wird, so daß eine elektrisch leitende Verbindung zwischen den Kontaktflächen des Chipmoduls (6) und den Kontaktflächen (2b) des Chipkartenkörpers (2) hergestellt wird.

4. Verfahren nach Anspruch 1 oder 2, **dadurch gekennzeichnet, dass** das haftende Verbinden des Chipmoduls (6) mit dem Chipkartenkörper (2) die folgenden Schritte umfasst:
- haftendes Aufbringen des erwärmten und aufgeschmolzenen Elastomermaterials (5) auf das Chipmodul (6) und zumindest teilweises Erstarren des Elastomermaterials (5),
- Aufbringen des Chipkartenkörpers (2) auf das zumindest teilweise erstarrte Elastomermaterial (5) des Chipmoduls (6),
- erneutes Erwärmen und Aufschmelzen des Elastomermaterials (5) durch den Chipkartenkörper (2) und/oder das Chipmodul (6) hindurch, so daß eine weitere haftende Verbindung zwischen dem Elastomermaterial (5) und den Kontaktflächen des Chipkartenkörpers (2) gebildet wird, so daß eine elektrisch leitende Verbindung zwischen den Kontaktflächen des Chipmoduls (6) und den Kontaktflächen (2b) des Chipkartenkörpers (2) hergestellt wird.

5. Verfahren nach einem der Ansprüche 3 oder 4, **dadurch gekennzeichnet, dass** das Elastomermaterial (5) mit einer herkömmlichen Dosiereinheit für Heißklebestoffe oder einer Spritzgussmaschine haftend aufgebracht wird.

6. Verfahren nach einem der Ansprüche 3 oder 4, **dadurch gekennzeichnet, dass** das Elastomermaterial (5) in Form einer Folie haftend aufgebracht wird.

7. Verfahren nach einem der Ansprüche 3 bis 6, **dadurch gekennzeichnet, dass** ein Elastomermaterial (5) mit leitfähigem Füllstoff haftend aufgebracht wird.

8. Verfahren nach Anspruch 7, **dadurch gekennzeichnet, dass** als Elastomermaterial (5) ein thermoplastisches Silikon haftend aufgebracht wird.

9. Verfahren nach einem der Ansprüche 3 bis 8, **dadurch gekennzeichnet, dass** ein Elastomermaterial (5) haftend aufgebracht wird, welches beim haftenden Verbinden des Chipmoduls (6) mit dem Chipkartenkörper (2) bei Temperaturen eine Haftverbindung mit dem Chipmodul (6) und/oder dem Chipkartenkörper (2) eingehen kann, die unterhalb einer maximalen Temperaturbelastung des Chipmoduls (6) und/oder des Chipkartenkörpers (2) liegen.

10. Verfahren nach einem der Ansprüche 3 bis 9, **dadurch gekennzeichnet, dass** ein Elastomermaterial (5) haftend aufgebracht wird, bei dem die Stärke der haftenden Verbindung zwischen dem Chipmodul (6) und dem Chipkartenkörper (2) optimiert ist.

11. Verfahren nach Anspruch 10, **dadurch gekennzeichnet, dass** ein Elastomermaterial (5) haftend aufgebracht wird, welchem ein Additiv beigemischt ist und/oder auf dessen Oberfläche ein Haftvermittler aufgebracht ist.

12. Chipkarte (1) mit Chipmodul (6), **dadurch gekennzeichnet, dass** das Chipmodul (6) mittels eines thermoplastischen, elektrisch leitfähigen Elastomermaterials (5) haftend mit einem Chipkartenkörper (2) der Chipkarte (1) verbunden ist, so dass das Chipmodul (6) mit zumindest einer elektrischen Kontaktfläche (2b) des Chipkartenkörpers (2) elektrisch leitend verbunden ist.

13. Chipkarte (1) nach Anspruch 12, **dadurch gekennzeichnet, dass** die Chipkarte (1) eine kontaktlose Kommunikationsschnittstelle (2a) umfasst, wobei die Chipkarte (1) insbesondere als Dual-Interface Chipkarte ausgebildet sein kann.

14. Chipkarte (1) nach Anspruch 12 oder 13, **dadurch gekennzeichnet, dass** die Chipkarte (1) eine in den Chipkartenkörper (2) eingebrachte Antenne (2a) umfasst, welche mit der zumindest einen elektrischen Kontaktfläche (2b) elektrisch leitend mit dem Chipmodul (6) verbunden ist.

15. Chipkarte (1) nach Anspruch 12 bis 14, **dadurch gekennzeichnet, dass** das Elastomermaterial (5) ein thermoplastisches Silikon mit leitfähigem Füllstoff ist.

16. Chipkarte (1) nach einem der Ansprüche 12 bis 15, **dadurch gekennzeichnet, dass** das Chipmodul (6) mittels eines Verfahrens gemäß einem der Ansprüche 1 bis 11 mit dem Chipkartenkörper (2) haftend verbunden wurde.

## Claims

1. A method for manufacturing a chip card (1) by electroconductively connecting a chip module (6) with a chip card body (2), **characterized in that** the chip module (6) is adhesively bonded with the chip card body (2) by means of a thermoplastic, electroconductive elastomeric material (5), so that the chip module (6) is connected electroconductively with at least one electric contact surface (2b) of the chip card body (2).

2. The method according to claim 1, **characterized in that** the chip module (6) is connected electroconductively with at least one electric contact surface (2b) of an antenna (2a) in the chip card body (2).

3. The method according to claim 1 or 2, **characterized in that** the adhesive bonding of the chip module (6) with the chip card body (2) comprises the following steps of:
- adhesively applying the heated and melted elastomeric material (5) at least to the at least one contact area (2b) of the chip card body (2) and at least partial solidification of the elastomeric material (5),
- applying the chip module (6) to the at least partially solidified elastomeric material (5) of the chip card body (2),
- reheating and melting the elastomeric material (5) through the chip card body (2) and/or the chip module (6), so that a further adhesive bond is formed between the elastomeric material (5) and the contact areas of the chip module (6), so that an electroconductive connection is established between the contact areas of the chip module (6) and the contact areas (2b) of the chip card body (2).

4. The method according to claim 1 or 2, **characterized in that** the adhesive bonding of the chip module (6) with the chip card body (2) comprises the following steps of:
- adhesively applying the heated and melted elastomeric material (5) to the chip module (6) and at least partial solidification of the elastomeric material (5),
- applying the chip card body (2) to the at least partially solidified elastomeric material (5) of the chip module (6),
- reheating and melting the elastomeric material (5) through the chip card body (2) and/or the chip module (6), so that a further adhesive bond is formed between the elastomeric material (5) and the contact areas of the chip card body (2), so that an electroconductive connection is established between the contact areas of the chip module (6) and the contact areas (2b) of the chip card body (2).

5. The method according to any of the claims 3 or 4, **characterized in that** the elastomeric material (5) is adhesively applied with a conventional metering unit for hotmelt adhesives or an injection-molding machine.

6. The method according to any of the claims 3 or 4, **characterized in that** the elastomeric material (5) is adhesively applied in the form of a foil.

7. The method according to any the claims 3 to 6, **characterized in that** an elastomeric material (5) is adhesively applied which has conductive filler.

8. The method according to claim 7, **characterized in that** as elastomeric material (5) a thermoplastic silicone is adhesively applied.

9. The method according to any of the claims 3 to 8, **characterized in that** an elastomeric material (5) is adhesively applied which can form an adhesive bond with the chip module (6) and/or the chip card body (2) upon adhesively bonding the chip module (6) with the chip card body (2) at temperatures that are below a maximum temperature load of the chip module (6) and/or the chip card body (2).

10. The method according to any of the claims 3 to 9, **characterized in that** an elastomeric material (5) is adhesively applied in which the strength of the adhesive bond between the chip module (6) and the chip card body (2) is optimized.

11. The method according to claim 10, **characterized in that** an elastomeric material (5) is adhesively applied to which an additive is admixed and/or on whose surface an adhesion promoter is applied.

12. A chip card (1) with a chip module (6), **characterized in that** the chip module (6) is adhesively bonded with a chip card body (2) of the chip card (1) by means of a thermoplastic, electroconductive elastomeric material (5), so that the chip module (6) is connected electroconductively with at least one electric contact area (2b) of the chip card body (2).

13. The chip card (1) according to claim 12, **characterized in that** the chip card (1) comprises a contactless communication interface (2a), wherein the chip card (1) can be configured in particular as a dual-interface chip card.

14. The chip card (1) according to claim 12 or 13, **characterized in that** the chip card (1) comprises an antenna (2a) incorporated in the chip card body (2), said antenna being electroconductively connected with the chip module (6) by the at least one electric contact area (2b).

15. The chip card (1) according to claim 12 to 14, **characterized in that** the elastomeric material (5) is a thermoplastic silicone with conductive filler.

16. The chip card (1) according to any of the claims 12 to 15, **characterized in that** the chip module (6) was adhesively bonded with the chip card body (2) by means of a method according to any of the claims 1 to 11.

## Revendications

1. Procédé de fabrication d'une carte à puce (1) par jonction électroconductrice d'un module puce (6) avec un corps de carte à puce (2), **caractérisé en ce que** le module puce (6) est joint par adhérence au corps de carte à puce (2) au moyen d'un matériau élastomère (5) électroconducteur thermoplastique, de telle sorte que le module puce (6) est joint de manière électroconductrice à au moins une surface de contact électrique (2b) du corps de carte à puce (2).

2. Procédé selon la revendication 1, **caractérisé en ce que** le module puce (6) est joint de manière électroconductrice à au moins une surface de contact électrique (2b) d'une antenne (2a) dans le corps de carte à puce (2).

3. Procédé selon la revendication 1 ou 2, **caractérisé en ce que** la jonction par adhérence du module puce (6) au corps de carte à puce (2) comprend les étapes suivantes :
- application par adhérence du matériau élastomère (5) chauffé et fondu au moins sur la au moins une surface de contact (2b) du corps de carte à puce (2) et au moins solidification partielle du matériau élastomère (5),
- application du module puce (6) sur le matériau élastomère (5) au moins partiellement solidifié du corps de carte à puce (2),
- de nouveau, chauffage et fusion du matériau élastomère (5) à travers le corps de carte à puce (2) et/ou le module puce (6), de telle sorte qu'une jonction supplémentaire par adhérence entre le matériau élastomère (5) et les surfaces de contact du module puce (6) est constituée, de telle sorte qu'une jonction électroconductrice entre les surfaces de contact du module puce (6) et les surfaces de contact (2b) du corps de carte à puce (2) est confectionnée.

4. Procédé selon la revendication 1 ou 2, **caractérisé en ce que** la jonction par adhérence du module puce (6) au corps de carte à puce (2) comprend les étapes suivantes :
- application par adhérence du matériau élastomère (5) chauffé et fondu sur le module puce (6) et au moins solidification partielle du matériau élastomère (5),
- application du corps de carte à puce (2) sur le matériau élastomère (5) au moins partiellement solidifié du module puce (6),
- de nouveau, chauffage et fusion du matériau élastomère (5) à travers le corps de carte à puce (2) et/ou le module puce (6), de telle sorte qu'une jonction supplémentaire par adhérence entre le matériau élastomère (5) et les surfaces de contact du corps de carte à puce (2) est constituée, de telle sorte qu'une jonction électroconductrice entre les surfaces de contact du module puce (6) et les surfaces de contact (2b) du corps de carte à puce (2) est confectionnée.

5. Procédé selon une des revendications 3 ou 4, **caractérisé en ce que** le matériau élastomère (5) est appliqué de manière adhérente au moyen d'une unité de dosage conventionnelle pour colles à chaud ou d'une machine de moulage par injection.

6. Procédé selon une des revendications 3 ou 4, **caractérisé en ce que** le matériau élastomère (5) est appliqué de manière adhérente sous forme d'un film.

7. Procédé selon une des revendications de 3 à 6, **caractérisé en ce qu'**un matériau élastomère (5) est appliqué de manière adhérente avec une matière de remplissage électroconductrice.

8. Procédé selon la revendication 7, **caractérisé en ce que**, en tant que matériau élastomère (5), c'est une silicone thermoplastique qui est appliquée de manière adhérente.

9. Procédé selon une des revendications de 3 à 8, **caractérisé en ce qu'**un matériau élastomère (5) est appliqué de manière adhérente, lequel, lors de la jonction par adhérence du module puce (6) au corps de carte à puce (2), peut entrer en liaison d'adhérence avec le module puce (6) et/ou avec le corps de carte à puce (2) à des températures qui se situent en dessous d'une charge thermique maximale du module puce (6) et/ou du corps de carte à puce (2).

10. Procédé selon une des revendications de 3 à 9, **caractérisé en ce qu'**un matériau élastomère (5) est appliqué de manière adhérente, dans le cas duquel la force de la jonction par adhérence entre le module puce (6) et le corps de carte à puce (2) est optimisée.

11. Procédé selon la revendication 10, **caractérisé en ce qu'**un matériau élastomère (5) est appliqué de manière adhérente, auquel un additif est incorporé et/ou sur la surface duquel un est agent adhésif appliqué.

12. Carte à puce (1) avec module puce (6), **caractérisée en ce que** le module puce (6), au moyen d'un matériau élastomère (5) électroconducteur thermoplastique, est joint par adhérence à un corps de carte à puce (2) de la carte à puce (1), de telle sorte que le module puce (6) est joint de manière électroconductrice à au moins une surface de contact électrique (2b) du corps de carte à puce (2).

13. Carte à puce (1) selon la revendication 12, **caractérisée en ce que** la carte à puce (1) comprend une interface de communication (2a) sans contact, la carte à puce (1) pouvant être réalisée notamment en tant que carte à puce dual interface.

14. Carte à puce (1) selon la revendication 12 ou 13, **caractérisée en ce que** la carte à puce (1) comprend une antenne (2a) enchâssée dans le corps de carte à puce (2) et jointe de manière électroconductrice par la au moins une surface de contact électrique (2b) au module puce (6).

15. Carte à puce (1) selon la revendication de 12 à 14, **caractérisée en ce que** le matériau élastomère (5) est une silicone thermoplastique avec matière de remplissage électroconductrice.

16. Carte à puce (1) selon une des revendications de 12 à 15, **caractérisée en ce que** le module puce (6) a été, au moyen d'un procédé selon une revendications de 1 à 11, joint par adhérence au corps de carte à puce (2).
